# EUROPEAN PATENT APPLICATION

(11) **EP 2 568 786 A1**
(43) Date of publication of application: **13.03.2013**
(21) Application number: 10165475.4
(22) Date of filing: 10.06.2010
(51) Int. Cl.: H05K 7/14

(54) **Apparatus for fixing a printed circuit board**

(71) Applicant: Thomson Licensing, 92130 Issy-les-Moulineaux (FR)
(72) Inventor: Huang, Wen Xin, 92443 Issy Les Moulineaux cedex (FR); Kiew, Kian Choy, 92443 Issy Les Moulineaux cedex (FR); Zhang, Ke, 92443 Issy Les Moulineaux cedex (FR)
(74) Representative: Ruellan-Lemonnier, Brigitte

(57) **Abstract**

An apparatus for fixing a printed circuit board is provided. The apparatus comprises a bottom member for accommodating the printed circuit board and an assembly member which can be detachably attached to the second part of the bottom member. The bottom member comprises a first part for the printed circuit board to be placed thereon, and a second part which is disposed upwards in a vertical direction at one edge of the first part and provided with at least one openings therein. The assembly member being integrally formed at the side towards the second part with at least one fixing member. When the assembly member is attached onto the second part of the bottom member, the fixing members will penetrate through the at least one openings of the second part to elastically fix the printed circuit board onto the first part of the bottom member.

## Description

### FIELD OF THE INVENTION

The present invention relates to an apparatus for fixing a printed circuit board (PCB).

### BACKGROUND OF THE INVENTION

The PCB is one of the important components of electronic equipments, which generally is fixed to a containing case of the electronic equipment by fastening screws or bending clips.

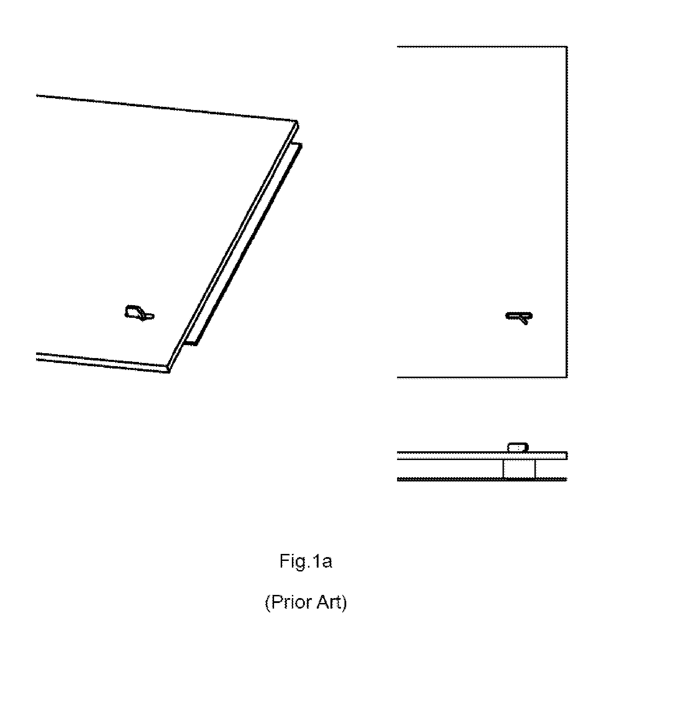

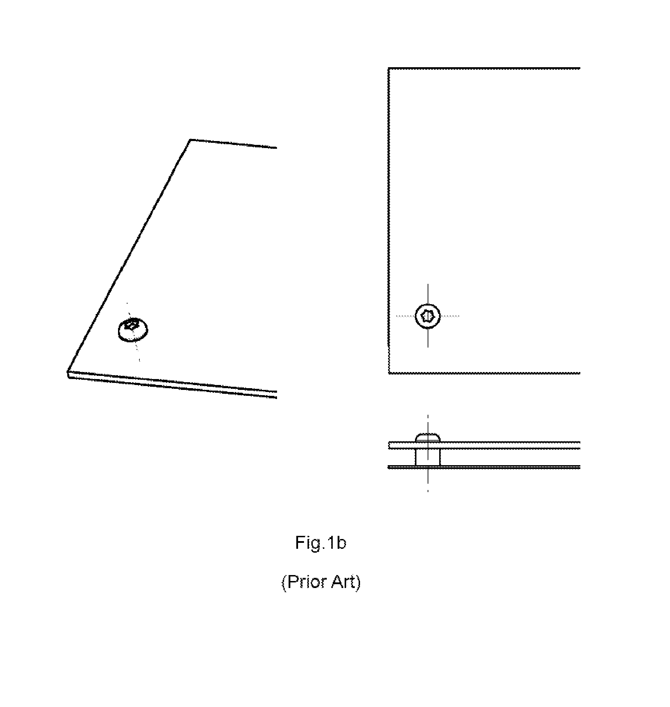

Figure 1 (a), (b) are exemplary diagrams showing a conventional PCB fixing structure. As shown in Figure 1(a), the PCB can be locked by a bending clip formed on the containing case. A screw can also be used to firmly fix the PCB onto the containing case, as shown in Figure 1 (b).

Such solution will cause a number of problems. For instance, a common disadvantage of the prior art structure is that the firmly-fixed PCB is not flexible enough when submitted to shocks, resulting in damage of the circuitry on the PCB.

In addition, complicated or inconvenient assembly steps of the screws or clips are required, which will inevitably increase the cost and the possibilities of incorrect manipulation during the manufacture and assembly process. For example, a worker is likely to forget to fasten the screws or the screws may be lost during the assembly procedure.

### SUMMARY OF THE INVENTION

In view of the above-described problems, the present invention was developed.

According to one aspect of the invention, there is provided an apparatus for fixing a printed circuit board, characterized by comprising:
a bottom member for accommodating the printed circuit board, the bottom member having
   a first part for the printed circuit board to be placed thereon, and
   a second part which is disposed orthogonally to the first part and provided with at least one opening therein,
an assembly member which can be detachably attached to the second part of the bottom member, the assembly member being integrally formed at the side towards the second part with at least one fixing member,
upon the attachment of the assembly member onto the second part of the bottom member, the fixing members being able to penetrate through said at least one opening of the second part to exert pressure on the printed circuit board towards the first part of the bottom member.

### BRIEF DESCRIPTION OF DRAWINGS

These and other aspects, features and advantages of the present invention will become apparent from the following description in connection with the accompanying drawings in which:
Figure 1(a), (b) are exemplary diagrams showing a conventional PCB fixing structure with fastening screws and bending clips;
Figure 2 is a perspective view showing the structure of a containing case, before assembled, for fixing a PCB in accordance with an embodiment of the present invention;
Figure 3 (a) to (f) are exemplary diagrams showing the procedure of fixing a PCB into the containing case in accordance with the embodiment of the present invention; and
Figure 4 is a perspective view showing the PCB assembled in the containing case in accordance with the embodiment of the present invention.

### DETAIL DESCRIPTION OF PREFERRED EMBODIMENTS

In the following description, various aspects of an embodiment of the present invention will be described. For purposes of explanation, specific configurations and details are set forth in order to provide a thorough understanding. However, it will also be apparent to one skilled in the art that the present invention may be practiced without the specific details present herein.

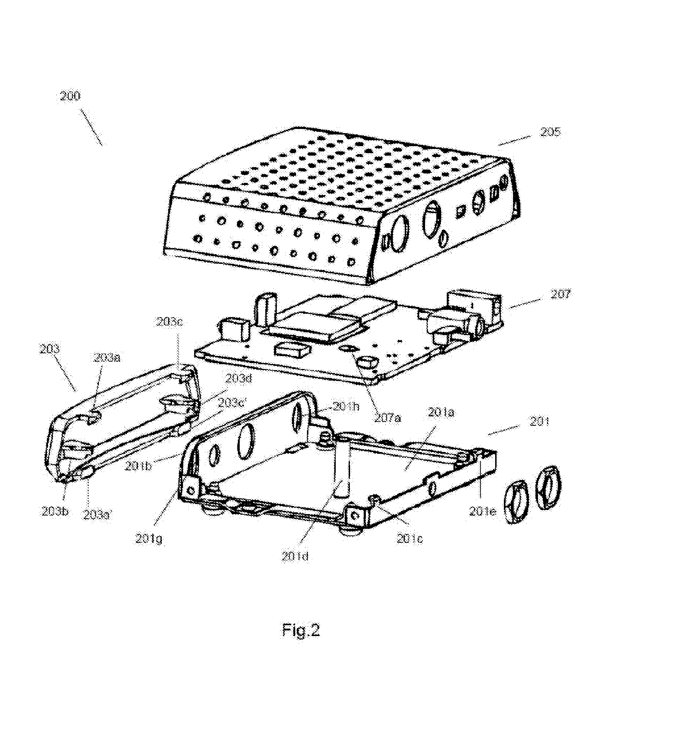

Figure 2 is an exemplary diagram showing the structure of a containing case 200, before assembly, for fixing a PCB 207 in accordance with an embodiment of the present invention.

Referring to Figure 2, the containing case 200 comprises a bottom cover 201, a window member 203 and a top cover 205. A PCB 207 can be fixed and housed in the containing case 200.

The bottom cover 201 is used to accommodate the PCB 207. As shown in Figure 2, the bottom cover 201 comprises a bottom board portion 201a and a side wall portion 201b which is disposed upwards in a vertical direction at one edge of the bottom board portion 201a.

The bottom board portion 201a can have a shape and size matched with the PCB 207 to receive the PCB 207 thereon. In this embodiment, two clips 201c, 201e are provided at the edge of the board portion 201a opposite to the one where the side wall portion 201b is disposed to lock one side of the PCB 207 after assembly. The bottom board portion 201a is also provided with a pillar 201d which extends upwards in vertical direction. The position of the pillar 201d on the bottom board portion 201a should correspond to that of a opening 207a in the PCB 207 when the PCB 207 is placed on the bottom board portion 201a. During assembly, when the PCB 207 is placed on the bottom board portion 201a in a correction orientation, the pillar 201d will penetrate through the opening 207a in the PCB 207 to hold the PCB 207 in position. It also acts as a guide to ensure correct placing of the PCB on the bottom part 201 of the case.

As shown in Figure 2, the window member 203 has a shape matched with that of the side wall portion 201b of the bottom cover 201. In this embodiment, the window member 203 is provided with two clips 203a, 203c at its top edge and two clips 203a', 203c' at its bottom edge that all project from the inner side of the front edge of the window member 203 in a direction so as to permit clipping of the window member 203 onto the bottom cover 201. As will described later, the two clips 203a, 203c, 203a', 203c' can be clipped onto the side wall portion 201b, by which the window member 203 is detachably attached to the bottom cover 201.

Two ribs 203b, 203d are integrally formed on the inner side of the window member 203, projecting in the same direction as that of the clips 203a, 203c, 203a', 203c'. The two ribs 203b, 203d protrude orthogonally from the window member 2003, extend downwardly and have a predetermined elasticity in that direction. The ribs 203b, 203d can be made of plastic to have the above said required elasticity. The position and extension length of the ribs 203b, 203d are set so that they can respectively penetrate through two openings 201 g, 201 h in the side wall portion 201b of the bottom cover 201. By pressing with a downward component on the PCB once the window member is clipped into position on the side wall member, the ribs elastically fix the PCB 207 onto the bottom board portion 201a of the bottom cover 201.

The top cover 205 can be attached to the bottom cover 201 after the window member 203 is attached to fix the PCB 207 in position, in order to further prevent the PCB 207 from damages by dust and other external influences.

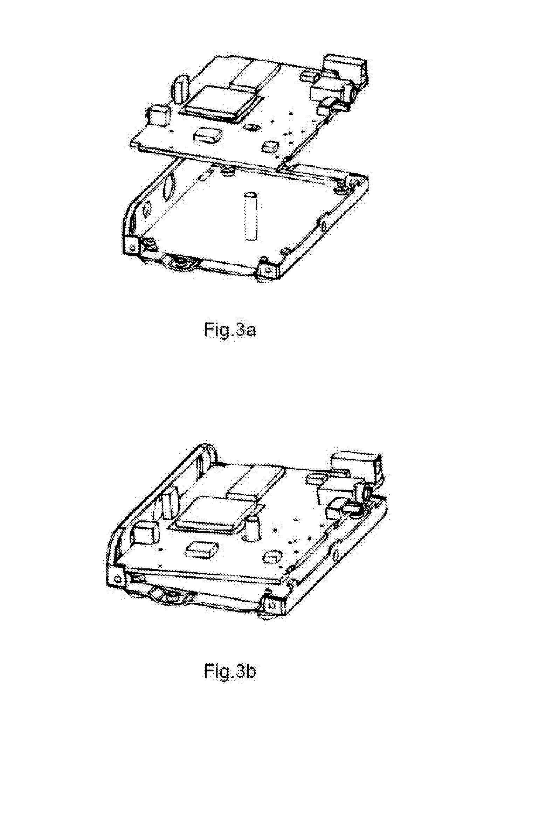

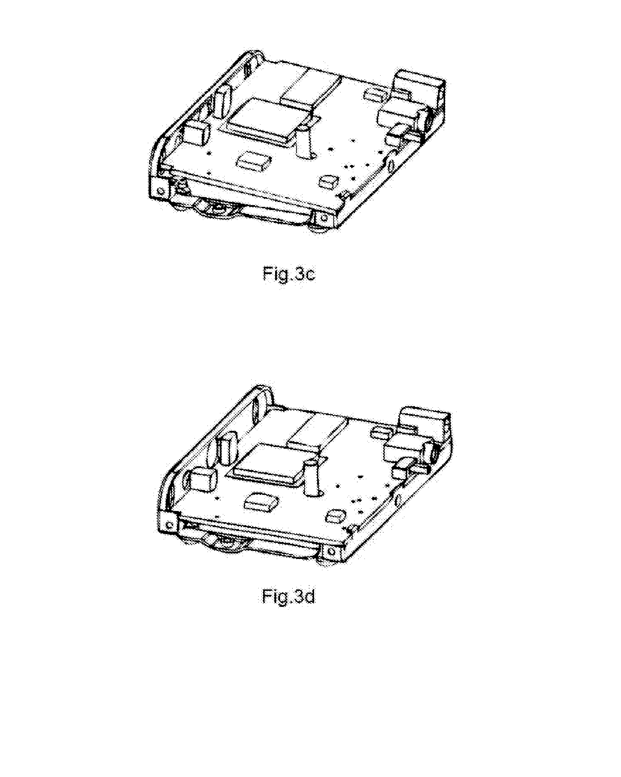

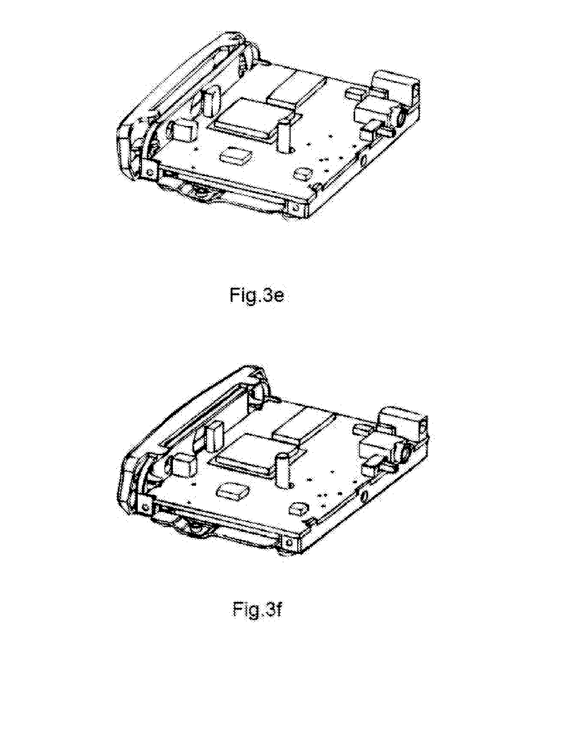

Next, the procedure of fixing the PCB 207 into the containing case 200 in accordance with an embodiment of the present invention will be described with reference to the Figure 3.

To assemble the PCB 207 into the containing case 200, as shown in figures 3(a) and 3(b), the PCB 207 is placed onto the bottom board portion 201a of the bottom cover 201 with the pillar 201d penetrating through the opening 207a of the PCB 207 for correctly positioning the PCB 207. Then, in the Figure 3(c) and 3(d) a slight push towards the bottom board portion 201a is applied onto the PCB 207 for locking the PCB 207 at one side with the clips 201c, 201e. After the above steps, the PCB 207 is put on the bottom board portion 201a with only one side locked by the clips 201c, 201e.

Next, the window member 203 is attached onto the bottom cover 201. As shown in Figure 3(e), firstly the ribs 203b, 203d are made to penetrate respectively through corresponding openings 201 g, 201 h formed on the side wall portion 201b of the bottom cover 201. Then, as illustrated in Figure 3(f), a slight force in the assembling direction is applied on the window member 203 to force on the side wall portion 201b, so that the two clips 203a, 203c at the top edge and two clips 203a', 203c' at the bottom edge of the window member 203 are clipped respectively onto the top and bottom edge of the side wall portion 201b of the bottom cover 201 and the two ribs 203b, 203d elastically fix the other side of the PCB 207 onto the bottom cover 201. At this time, the PCB 207 is securely fixed to the containing case 200, with its one side locked by the clips 201c, 201e and the other side elastically fixed by the ribs 203b, 203d.

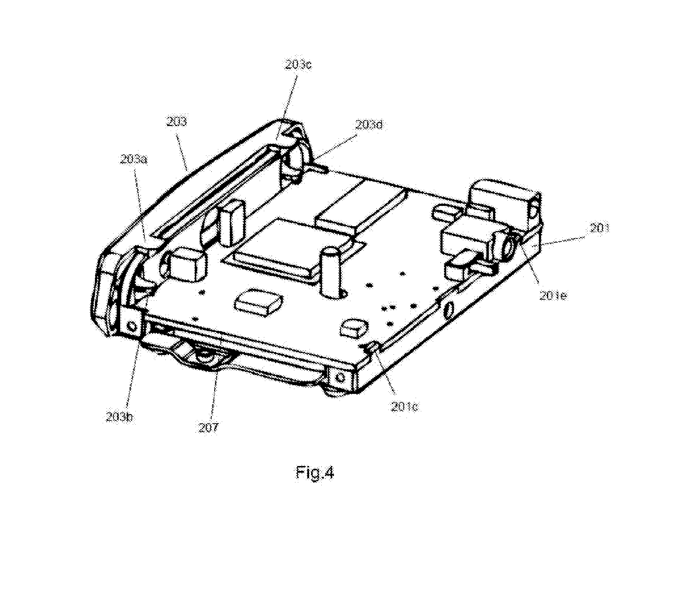

Figure 4 is a perspective view showing the PCB 207 assembled in the containing case 200.

As clearly shown in Figure 4, the PCB 207 is locked at one side by the two clips 201c, 201e and elastically fixed at the other side with the two ribs 203b, 203d.

It should be appreciated that, although not shown in Figures 3 and 4, the top cover 205 can be assembled to the bottom cover 201 with the conventional means to further protect the PCB 207 from damages by outer forces.

As with the embodiment described above, a PCB can be mounted in a containing case without using separate, mechanically distinct fastening components, such as screws and clips. Therefore, when the window member is assembled in position, the PCB will be automatically fixed by the ribs which are integrally formed on the window member, by which misoperation during the assembly procedure can be avoided. In addition, since the PCB is fixed at one side by the elastic ribs, impact or shock from outer environment can be partly absorbed, which will provide more protections for the electrics devices on the PCB from cracking under impact.

From the foregoing description, it will be evident for a person skilled in the art that numerous modifications may be made to the illustrative embodiments and that other arrangements may be devised without departing from the spirit and scope of the present invention as defined by the appended claims. In particular, while in the above embodiment, the protruding elements of the window member 203 are formed as ribs 203b and 203d, such protruding elements may have other shapes as long as they exert downward pressure on the PCB when the window member 203 is mounted.

## Claims

1. An apparatus (200) for fixing a printed circuit board (207), **characterized by** comprising:
a bottom member (201) for accommodating the printed circuit board (207), the bottom member (201) having
a first part (201a) for the printed circuit board (207) to be placed thereon, and
a second part (201b) which is disposed orthogonally to the first part (201a) and provided with at least one opening (201 g, 201 h) therein,
an assembly member (203) which can be detachably attached to the second part (201b) of the bottom member (201), the assembly member (203) being integrally formed at the side towards the second part (201b) with at least one fixing member (203b, 203d),
upon the attachment of the assembly member (203) onto the second part (201b) of the bottom member (201), the fixing members (203b, 203d) being able to penetrate through said at least one opening (201 g, 201 h) of the second part (201b) to exert pressure on the printed circuit board (207) towards the first part (201a) of the bottom member (201).

2. The apparatus according to claim 1, wherein the fixing member (203b) is a rib made of plastic to have elasticity in the direction of fixing the printed circuit board (207) onto the first part (201a) for the printed circuit board (207).

3. The apparatus according to claim 1, wherein the assembly member (203) has a shape matched with that of the second part (201b) of the bottom member (201).

4. The apparatus according to claim 3, wherein the assembly member (203) is provided with at leas two clips (203a, 203c, 203a', 203c') respectively formed at its top and bottom edges that can be clipped onto the second part (201b) of the bottom member (201).

5. The apparatus according to claim 1, wherein the first part (201a) of the bottom member (201) has a shape matched with that of the printed circuit board (207) to be placed thereon.

6. The apparatus according to claim 5, wherein the first part (201a) of the bottom member (201) is provided with a pillar (201d) which extends upwards in vertical direction at a position corresponding to that of a opening (207a) in the printed circuit board (207) when the printed circuit board (207) is placed on the first part (201a).

7. The apparatus according to claim 5, wherein the first part (201a) of the bottom member (201) is provided with at least one clips (201c, 201e) at the edge opposite to the one where the second part (201b) is disposed to lock one side of the printed circuit board (207) after assembled.

8. The apparatus according to claim 1, further comprising a top member (205) that can be assembled to the bottom member (201) to further protect the PCB 207 from damages by outer forces.
